# EUROPÄISCHE PATENTSCHRIFT

(11) **EP 0 662 220 B1**
(45) Veröffentlichungstag und Bekanntmachung des Hinweises auf die Patenterteilung: **20.11.1996**
(21) Anmeldenummer: 93918952.8
(22) Anmeldetag: 07.09.1993
(51) Int. Cl.: G01R 31/06, G01R 31/34

(54) **AUSKOPPLUNG EINES HOCHFREQUENTEN FEHLERSIGNALS AUS EINEM HOCHFREQUENTEN ELEKTROMAGNETISCHEN FELD IN EINER ELEKTRISCHEN GROSSMASCHINE**
DECOUPLING OF A HIGH-FREQUENCY ERROR SIGNAL FROM A HIGH-FREQUENCY ELECTROMAGNETIC FIELD IN A LARGE ELECTRIC MACHINE
DECOUPLAGE D'UN SIGNAL D'ERREUR HAUTE FREQUENCE D'UN CHAMP ELECTROMAGNETIQUE HAUTE FREQUENCE DANS UNE MACHINE ELECTRIQUE DE GRANDE DIMENSION

(30) Priorität: 22.09.1992 DE 4231714
(43) Veröffentlichungstag der Anmeldung: 12.07.1995
(73) Patentinhaber: SIEMENS AKTIENGESELLSCHAFT, 80333 München (DE)
(72) Erfinder: GRÜNEWALD, Peter, D-45149 Essen (DE); WEIDNER, Jürgen, D-45277 Essen (DE); KOZIEL, Reinhold, D-45475 Mülheim an der Ruhr (DE)
(86) Internationale Anmeldenummer: DE9300815
(87) Internationale Veröffentlichungsnummer: WO9407152

(56) Entgegenhaltungen:
- EP-A- 0 228 613
- US-A- 4 949 001
- ELEKTROTECHNIK 1979 , WURZBURG DE Seiten 27 - 30 RAASCH 'MESSEN UND UBERWACHEN VON TEMPERATUREN AN GROSSEN ASYNCHRONMOTOREN'
- IEEE TRANSACTIONS ON POWER APPARATUS AND SYSTEMS Bd. 102, Nr. 4 , April 1983 , NEW YORK US Seiten 928 - 933 MICHIGUCHI ET AL. 'DEVELOPMENT OF A COLLECTOR RING MONITOR FOR SPARKING DETECTION ON GENERATORS'
- ELEKTROTECHNIK 1979, WüRZBURG DE, Seiten 27 - 30;RAASCH:'MESSEN UND üBERWACHEN VON TEMPERATUREN AN GROSSEN ASYNCHRONMOTOREN'

## Beschreibung

Die Erfindung betrifft die Auskopplung eines hochfrequenten Fehlersignals aus einem hochfrequenten elektromagnetischen Feld in einer elektrischen Großmaschine mit einem eine elektrische Wicklung tragenden Ständer.

Die Erfindung bezieht sich dabei insbesondere auf die betriebliche Überwachung einer elektrischen Großmaschine, vor allem auf die Erkennung von Schäden. Im einzelnen wird Bezug genommen auf Schäden, die beim Betrieb in der elektrischen Großmaschine zu Funkenbildungen führen.

Unter elektrischen Großmaschinen werden im vorliegenden Zusammenhang insbesondere Großgeneratoren wie z. B. Turbogeneratoren verstanden, deren elektrische Leistungen 50 MVA und mehr betragen.

Die Erkennung von Schäden in Anlagen mit elektrischen Großmaschinen findet ein ständig wachsendes Interesse im Bestreben, die Verfügbarkeit der Anlagen zu erhöhen und Schäden möglichst frühzeitig, womöglich sogar vorausschauend und vorzugsweise während des regulären Betriebs, zu erkennen. Dabei ist auch von Bedeutung, daß digitale Rechenanlagen zur Auswertung der Signale aus komplexen Überwachungssystemen in zunehmendem Umfang kostengünstig zur Verfügung stehen.

Verfahren und Vorrichtungen zur Erkennung eventuell auch Lokalisierung, von Schäden in elektrischen Anlagen, insbesondere in Anlagen mit elektrischen Großmaschinen, gehen hervor aus der DE-34 08 256 C2, der DE-35 26 149 A1, der DE-39 18 116 A1, der EP-0228 613 B1 und der EP 0241 764 B1. Aus diesen Schriften sind sowohl ganze Systeme zur Erkennung und Lokalisierung von Schäden in elektrischen Anlagen mit Auswertungen von hochfrequenten Fehlersignalen als auch Einzelheiten zur Auskopplung hochfrequenter Fehlersignale aus hochfrequenten Feldern in elektrischen Großmaschinen erkennbar. Das US-Patent 4,949,001 betrifft den Nachweis von Teilentladungen in dem Ständer einer dynamoelektrischen Großmaschine, insbesondere eines Turbogenerators. Patentgemäß wird auf den Ständer ein in Streifenleitertecnnik ausgebildeter und als Antenne zur Auskopplung eines hochfrequenten Fehlersignals dienender Meßwertaufnehmer nach Art eines Richtkopplers aufgelegt und über entsprechende Anschlußleitungen mit einer Auswerteeinrichtung verbunden. Durch Auswertung der Höhe und/oder des zeitlichen Verlaufs des Fehlersignals soll eine Lokalisierung der Stelle, von der das Fehlersignal ausgegangen ist, erfolgen. Auf den Inhalt aller zitierten Dokumente wird zur Vermeidung weiterer Wiederholungen an dieser Stelle ausdrücklich Bezug genommen.

Ein wichtiger Gesichtspunkt bei der Auskopplung hochfrequenter Fehlersignale aus einer elektrischen Großmaschine ist die bestmögliche Ausnutzung ohnehin vorhandener Bauteile und Einrichtungen, um die von Fehlern oder dgl. verursachten hochfrequenten elektromagnetischen Felder nicht durch zusätzliche Bauteile zu beeinträchtigen oder gar abzuschirmen; darüber hinaus sind auch ökonomische Gesichtspunkte zu beachten, die allzu komplexe Systeme von Sensoren unvorteilhaft erscheinen lassen können. Schließlich sprechen auch Erwägungen zur Belastbarkeit und zum Wirkungsgrad der elektrischen Großmaschinen gegen eine allzu großzügige Gewährung von Platz für Systeme zur Betriebsüberwachung.

Aus dem Aufsatz "Messen und Überwachen von Temperaturen an großen Asynchronmotoren" von W. Raasch, Elektro-Jahr 1979, Vogel-Verlag, Würzburg, DE, Seiten 27 bis 30, geht eine elektrische Großmaschine in Form eines Asynchronmotors hervor mit einem eine elektrische Wicklung tragenden Ständer, wobei die Wicklung in Nuten des Ständers eingelegt ist und wobei in einer Nut ein Temperaturmeßfühler angeordnet ist.

Die Erfindung basiert auf der Aufgabe, eine Möglichkeit zur Auskopplung eines hochfrequenten Fehlersignals aus einer elektrischen Großmaschine anzugeben, bei der weitestgehend ausschließlich auf ohnehin vorhandene Einrichtungen zurückgegriffen wird. Es sollen hierzu sowohl Verfahren als auch Vorrichtungen angegeben werden.

Das erfindungsgemäße Verfahren zur Auskopplung eines hochfrequenten Fehlersignals aus einem hochfrequenten elektromagnetischen Feld in einer elektrischen Großmaschine mit einem eine elektrische Wicklung tragenden und mit zumindest einem Temperaturfühler bestückten Ständer beruht darauf, daß der Temperaturfühler als Antenne zur Auskopplung des Fehlersignals benutzt wird.

Erfindungsgemäß wird zur Auskopplung des hochfrequenten Fehlersignals auf eine in der Regel ohnehin vorhandene Überwachungseinrichtung, nämlich eine Überwachungseinrichtung für die Betriebstemperatur mit zumindest einem Temperaturfühler, zurückgegriffen. Auf die spezielle Art des Temperaturfühlers kommt es dabei nur insoweit an, als daß dieser Temperaturfühler als Antenne für hochfrequente Signale geeignet sein muß. Dies bedeutet vor allem, daß er zumindest teilweise eine hinreichende elektrische Leitfähigkeit sowie nicht allzu kleine Abmessungen aufweisen sollte. Dies ist allerdings bei den Üblicherweise eingesetzten Temperaturfühlern der Fall. Vielfach werden nämlich Temperaturfühler mit temperaturabhängigen elektrischen Widerständen benutzt, die mit immerhin viele Zentimeter langen Anschlußleitungen versehen sind; auch kommen ohne weiteres sämtliche Temperaturfühler in Frage, die metallische Hüllrohre oder ähnliche Bauteile haben und ansonsten in nahezu beliebiger Weise zu betreiben sein können. Temperaturfühler sind auch deshalb besonders vorteilhaft, weil sie in einem Ständer einer elektrischen Großmaschine stets in der Nähe der (erhöhte Temperaturen erzeugenden) elektrischen Wicklung angeordnet sind, also in der Nähe des für Funkenbildungen kritischsten Teils. Dementsprechend ist auch die Stärke der einem üblichen Temperaturfühler abnehmbaren hochfrequenten Signale kein Problem, da durch die Nähe zu den möglichen Fehlerquellen in aller Regel ein recht starkes hochfrequentes elektromagnetisches Feld in der Umgebung des Temperaturfühlers und damit eine hinreichende Stärke des mittels des Temperaturfühlers erhaltenen Fehlersignals gewährleistet ist. Darüber hinaus ist jedenfalls die von einem Temperaturfühler gemessene Temperatur in einer elektrischen Großmaschine eine zeitlich nur sehr wenig veränderliche Größe, die von einem sehr niederfrequenten Signal, praktisch einem Signal der Frequenz Null, darstellbar ist und somit eine problemlose Trennung zwischen Temperatursignalen und hochfrequenten Fehlersignalen erlaubt.

Daß günstigerweise im Rahmen der Erfindung elektrisch betriebene Temperaturfühler eingesetzt werden, insbesondere Temperaturfühler, die mit elektrischer Gleichspannung oder elektrischem Gleichstrom betrieben werden, wurde bereits erwähnt. Besonders geeignet ist ein Temperaturfühler, der ein in dem Ständer der elektrischen Großmaschine liegendes Fühlerelement mit daran angeschlossenen, aus dem Ständer herausführenden Anschlußleitungen aufweist. Bei einem solchen Temperaturfühler können die Anschlußleitungen unmittelbar als Antennen wirken, insbesondere als Viertelwellenantennen. Auch können mit einem solchen Temperaturfühler hochfrequente Fehlersignale gewonnen werden, welche durch das der Gewinnung der Temperatursignale dienende Fühlerelement nicht beeinflußt sind. Beispielsweise führen von dem Fühlerelement zwei miteinander verdrillte elektrische Anschlußleitungen ab, die zur Ableitung der hochfrequenten Fehlersignale gleichphasig angezapft werden. Dann wirken die Anschlußleitungen wie eine einzige Antenne, und das Fühlerelement trägt je nach Ausgestaltung überhaupt nicht oder nur sehr wenig zu den Fehlersignalen bei. Keinen Beitrag ergäbe beispielsweise ein Fühlerelement, das lediglich ein räumlich kleines Widerstandselement mit temperaturabhängigem elektrischem Widerstand ist. In jedem Falle ist es vorteilhaft, die Fehlersignale gleichzeitig mit den Temperatursignalen von dem Temperaturfühler abzunehmen und nachfolgend von diesen zu entkoppeln. Dies ist besonders einfach dann möglich, wenn die Temperatursignale niederfrequente Signale, insbesondere Gleichstromsignale oder Gleichspannungssignale, sind.

Eine besonders günstige Weiterbildung des erfindungsgemäßen Verfahrens ist dadurch gekennzeichnet, daß in einer Vielzahl in der elektrischen Großmaschine vorhandene Temperaturfühler als Antennen benutzt werden. Vorteilhafterweise sind die vielzähligen Temperaturfühler im wesentlichen gleichmäßig über den Ständer verteilt, so daß die Fehlersignale der Temperaturfühler zueinander korreliert werden können zur Ermittlung einer Stelle in der Großmaschine, wo sie verursacht wurden. Diese Ausgestaltung macht vorteilhaften Gebrauch von der Tatsache, daß hochfrequente elektromagnetische Felder in einer elektrischen Großmaschine bei ihrer Ausbreitung beträchtlich gedämpft werden, so daß die mit den von einer bestimmten Stelle ausgehenden hochfrequenten Feldern erhaltbaren Fehlersignale bezüglich ihrer Stärke wesentlich von der Positionierung eines zur Auskopplung benutzten Temperaturfühlers abhängen. Mit einer hinreichenden Vielzahl von Temperaturfühlern kann daher aus einer Bewertung der Stärken (und unter Umständen auch der Phasenlagen) der erhaltenen Fehiersignale auf die Stelle geschlossen werden, wo die Fehlersignale verursacht wurden.

Die erfindungsgemäße Vorrichtung zur Auskopplung eines hochfrequenten Fehlersignals aus einem hochfrequenten elektromagnetischen Feld in einer elektrischen Großmaschine mit einem eine elektrische Wicklung tragenden Ständer ist ausgezeichnet durch zumindest einen in dem Ständer angeordneten Temperaturfühler zur Erzeugung eines niederfrequenten Temperatursignals, mit Anschlußleitungen, die aus dem Ständer herausführen, und einen Diplexer zur Entkopplung des Fehlersignals von dem Temperatursignal, mit einem Eingang, einem ersten Ausgang und einem zweiten Ausgang, an welchem Eingang die Anschlußleitungen angeschlossen sind, an welchem ersten Ausgang das Temperatursignal und an welchem zweiten Ausgang das Fehlersignal bereitgestellt wird.

Die erfindungsgemäße Vorrichtung stellt ein Fehlersignal bereit, welches von einem in dem Ständer angeordneten Temperaturfühler abgenommen und von einem ebenfalls dem Temperaturfühler entstammenden Temperatursignal entkoppelt ist. Wie bereits angedeutet, ist der Temperaturfühler vorzugsweise elektrisch betreibbar und liefert als Temperatursignal ein niederfrequentes Signal, vorzugsweise ein Gleichstromsignal; in diesem Fall ist der Diplexer günstigerweise so ausgestattet, daß er bezüglich des ersten Ausgangs als Tiefpaßfilter und bezüglich des zweiten Ausgangs als Hochpaßfilter wirkt. Dies bedeutet, daß der Diplexer ein am Eingang eingespeistes niederfrequentes Signal dem ersten Ausgang und ein am Eingang eingespeistes hochfrequentes Signal dem zweiten Ausgang zustellt. Es versteht sich, daß den Ausgängen des Diplexers ggf. weiter Filter, insbesondere Hochpaß-, Tiefpaß- oder Bandpaßfilter, nachgeschaltet sein können. Auch können Verstärker und andere Signalverarbeitungseinrichtungen selbstverständlich einbezogen sein.

Der Temperaturfühler der Vorrichtung liegt vorzugsweise in einer Nut, welche zu einer Vielzahl von Nuten des Ständers gehört, in welche Wicklungsstäbe der Wicklung eingelegt sind. Auf diese Weise ist der Temperaturfühler der Wicklung, an welcher Funkenbildungen und dergleichen in erster Linie auftreten können, unmittelbar benachbart, wodurch ein recht starkes hochfrequentes elektromagnetisches Feld in der Umgebung des Temperaturfühlers und damit eine hinreichende Stärke der von dem Temperaturfühler abzunehmenden Fehlersignale gewährleistet ist. Besonders bevorzugt ist es dabei, daß der Temperaturfühler in einer elektrisch isolierenden Zwischenlage, die in einer Nut zwischen zwei in der Nut übereinanderliegenden Wicklungsstäben angeordnet ist, liegt. Auf diese Weise ist der Temperaturfühler empfindlich für hochfrequente elektromagnetische Felder, die von beiden Wicklungsstäben in der Nut ausgehen, und er befindet sich in einer elektrisch isolierenden Schicht, in der die Ausbreitung hochfrequenter elektromagnetischer Felder relativ gut möglich ist.

Günstig ist auch, wenn der Temperaturfühler als eigentliches Fühlerelement zur Bildung der Temperatursignale ein Widerstandselement mit einem temperaturabhängigen elektrischen Widerstand aufweist.

Besonders günstig ist es, wenn in der Vorrichtung eine Vielzahl von Temperaturfühlern zur Lieferung von Temperatursignalen und Fehlersignalen vorgesehen sind, wobei die Temperaturfühler vorzugsweise gleichmäßig über den Ständer verteilt sind.

Die Erfindung ermöglicht in besonders günstiger Weise den Nachweis einer Funkenbildung in einer elektrischen Großmaschine, wobei aus dem Auftreten eines hochfrequenten Fehlersignals an einem Temperaturfühler auf eine Funkenbildung geschlossen wird. Insbesondere ermöglicht die Erfindung eine besonders günstige Erkennung und, im Rahmen einer Weiterbildung Lokalisierung eines Schadens.

Ein erfindungsgemäß auszukoppelndes hochfrequentes Fehlersignal liegt vorteilhafterweise in einem Frequenzbereich zwischen 1 MHz und 300 MHz, insbesondere zwischen 3 MHz und 100 MHz. Zum Nachweis von hochfrequenten Fehlersignalen mit solchen Frequenzen sind Temperaturfühler mit üblichen geometrischen Abmessungen besonders geeignet.

Ausführungsbeispiele der Erfindung werden nun anhand der Zeichnung erläutert. Zur Verdeutlichung bestimmter Merkmale ist die Zeichnung teilweise schematisiert und/oder nicht maßstäblich ausgeführt. Insbesondere wurde teilweise auf die Darstellung einschlägig bekannter und im vorliegenden Zusammenhang nicht wesentlicher Komponenten verzichtet. Im einzelnen zeigen:
Fig. 1 einen schematisierten axialen Längsschnitt durch eine elektrische Großmaschine mit erfindungsgemäß zu benutzenden Temperaturfühlern;
Fig. 2 einen schematisierten radialen Querschnitt durch die in Fig. 1 dargestellte Maschine;
Fig. 3 und Fig. 4 Ausführungsbeispiele für im Sinne der Erfindung ertüchtigte Temperaturfühler.

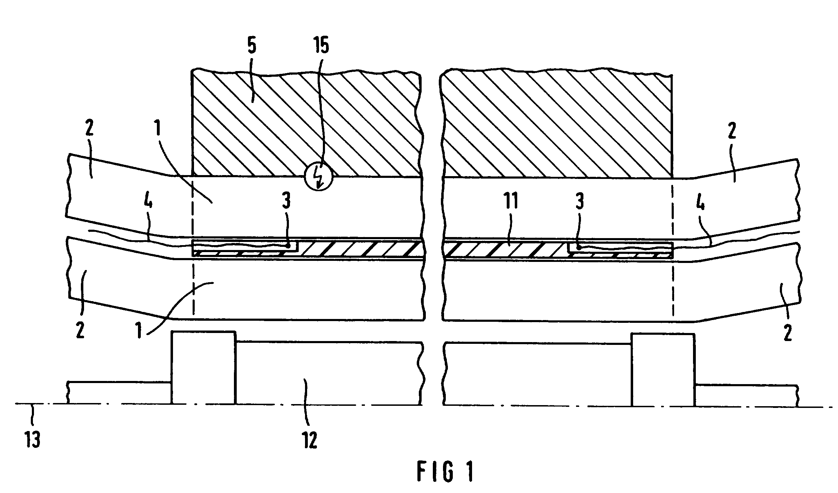

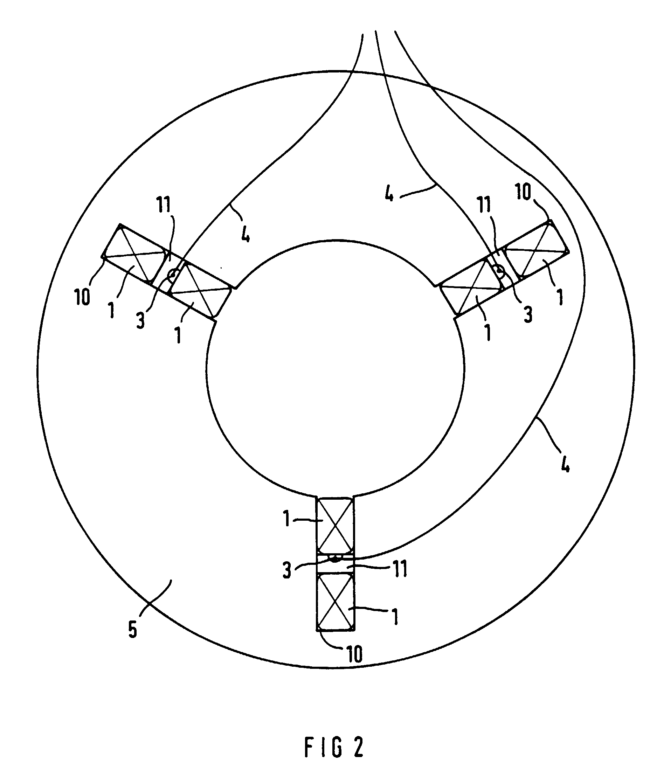

Fig. 1 zeigt einen entlang der Achse 13 ausgeführten Längsschnitt durch eine elektrische Großmaschine mit einem Ständer 5 und einem in einer Ausnehmung des Ständers 5 angeordneten, um die Achse 13 drehbaren Rotor 12. Der Ständer 5 weist Nuten 10 auf (siehe Fig. 2), in denen zwei elektrische Wicklungsstäbe 1, 2 als Bestandteile der elektrischen Wicklung angeordnet sind. Jeder Wicklungsstab 1, 2 hat ein gerades Segment 1, welches in der Nut 10 liegt, sowie zwei Bögen 2, jeweils einen an jedem Ende des geraden Segmentes 1. Die Bögen 2 verlaufen außerhalb der Nut 10 und dienen der Verbindung verschiedener Wicklungsstäbe miteinander. Zwischen den geraden Segmenten 1 liegt eine Zwischenlage 11 aus isolierendem Material. An jedem Ende des Ständers 5 liegt in der Zwischenlage 11 ein Temperaturfühler 3, 4 mit einem Fühlerelement 3, insbesondere einem Widerstandselement mit einem temperaturabhängigen elektrischen Widerstand, und Anschlußleitungen 4, welche aus dem Ständer 5 herausführen und an Signalverarbeitungseinrichtungen zur Auswertung der Temperatursignale und Fehlersignale anzuschließen sind. Diese Signalverarbeitungseinrichtungen sind in Fig. 1 nicht dargestellt. Die zwei Temperaturfühler 3, 4 können herangezogen werden zur Ortung eines Schadens 15, an dem beim Betrieb der elektrischen Großmaschine eine Funkenbildung, beispielsweise im Rahmen einer Teilentladung, auftritt. Dadurch, daß der Schaden 15 dem links dargestellten Temperaturfühler 3, 4 wesentlich näher ist als dem rechts dargestellten, ist das im linken Temperaturfühler 3, 4 auftretende Fehlersignal wesentlich größer als das Fehlersignal, welches dem rechten Temperaturfühler 3, 4 entnehmbar ist. Aus diesem einfachen Beispiel ist ersichtlich, wie eine Ortung des Schadens 15 möglich ist. Das somit vorliegende Ortungssystem für Fehlersignale ist vorteilhaft ergänzbar um weitere Temperaturfühler, insbesondere um Temperaturfühler etwa in der Mitte des Ständers 5.

Es sei nochmals darauf hingewiesen, daß Fig. 1 nicht alle üblichen Merkmale einer elektrischen Großmaschine zeigt. So ist der Ständer 5 dargestellt als kompakter Block, was nicht unbedingt der üblichen Praxis entspricht. Auch sind nicht dargestellt Mittel zum Verschließen der Nuten, in denen die Wicklungsstäbe 1, 2 liegen. Weiterhin sind die dargestellten Größenverhältnisse nicht maßstabsgerecht. Für eine Ergänzung der aus Fig. 1 und den nachfolgenden Figuren entnehmbaren Hinweise wird insoweit auf das allgemeine Fachwissen des einschlägig tätigen Durchschnittfachmanns verwiesen.

Fig. 2 zeigt einen senkrecht zur Achse gelegten Querschnitt durch die in Fig. 1 dargestellte Maschine. Der Ständer 5 weist Nuten 10 auf, in die die geraden Segmente 1 der Wicklungsstäbe 1, 2 eingelegt sind. Dargestellt sind drei Nuten 10 als Repräsentanten für die üblicherweise in elektrischen Großmaschinen in großer Vielzahl vorhandenen Nuten 10. In jeder Nut 10 befinden sich übereinander zwei gerade Segmente 1, und zwischen diesen eingefügt ist eine Zwischenlage 11. In jeder Zwischenlage 11 befindet sich ein Fühlerelement 3 mit Anschlußleitungen 4.

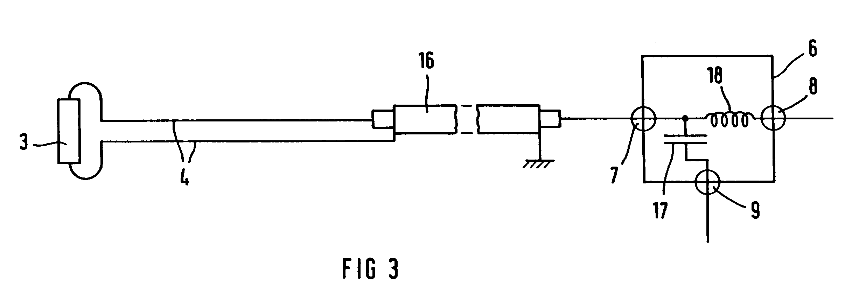

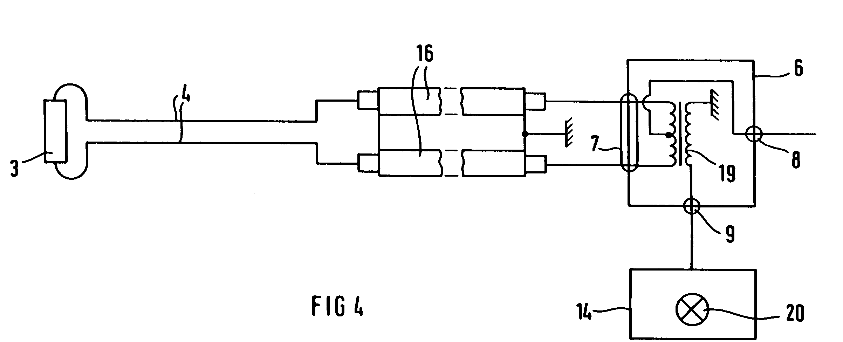

Die Fig. 3 und 4 zeigen zwei Ausführungsbeispiele für als Antennen benutzbare Temperaturfühler aus Fühlerelementen 3, insbesondere Widerstandselementen mit temperaturveränderlichen elektrischen Widerständen, Anschlußleitungen 4 und Diplexern 6 zur Entkopplung der Fehlersignale von den Temperatursignalen. Gemäß Fig. 3 sind die Anschlußleitungen 4 an ein Koaxialkabel 16 angeschlossen, und zwar eine Anschlußleitung 4 an den Innenleiter und eine andere Anschlußleitung 4 an den Außenleiter, der seinerseits geerdet ist. Aus dem Koaxialkabel 16 wird das von dem Temperaturfühler erhaltene Gemisch aus Temperatursignal und Fehlersignal dem Eingang 7 eines Diplexers 6 zugeführt. In dem Diplexer 6 erfolgt die Entkopplung des Fehlersignals von dem Temperatursignal. Das Temperatursignal wird vom Eingang 7 über eine Spule 18, welche ein Tiefpaßfilter zum Durchlaß von Signalen mit niedrigen Frequenzen bildet, dem ersten Ausgang 8 des Diplexers 6 zugeführt, und das Fehlersignal gelangt vom Eingang 7 über einen Kondensator 17 zum zweiten Ausgang 9 des Diplexers 6. Der Kondensator 17 bildet ein Hochpaßfilter, welches nur hochfrequente Signale passieren läßt. Vom zweiten Ausgang 9 des Diplexers 6 ist das Fehlersignal einer nicht dargestellten Auswerteeinrichtung zuführbar. Die genaue Funktion des aus Fühlerelement 3 und Anschlußleitungen 4 gebildeten Temperaturfühlers als Antenne für das hochfrequente Fehlersignal hängt natürlich wesentlich von der Frequenz des Fehlersignals und den geometrischen Abmessungen des Temperaturfühlers ab; mit dem Temperaturfühler nach Fig. 3 wird jedoch im wesentlichen eine kapazitive Kopplung an ein hochfrequentes elektromagnetisches Feld in der elektrischen Großmaschine erreicht.

Fig. 4 zeigt eine andere Ausgestaltung des Temperaturfühlers, bei dem die Anschlußleitungen 4 mit dem Fühlerelement 3 im wesentlichen als eine induktiv wirkende Antenne für hochfrequente Signale dienen. Nach Fig. 4 ist der Temperaturfühler angeschlossen an zwei Koaxialkabel 16 mit geerdeten Außenleitern; die Anschlußleitungen 4 sind an die Innenleiter der Koaxialkabel 16 angeschlossen. Der Eingang 7 des Diplexers 6 ist ausgebildet zum Anschluß beider Koaxialkabel 16. Die Entkopplung des Fehlersignals von dem Temperatursignal erfolgt mittels eines Transformators 19. Die Primärwicklung des Transformators 19, die mit dem Eingang 7 verbunden ist, weist eine Mittenanzapfung auf oder ist bifilar gewickelt, wobei ein einer Mittenanzapfung entsprechender Anschluß vorgesehen ist. An die Mittenanzapfung der Primärwicklung angeschlossen ist der erste Ausgang 8 zur Ableitung des niederfrequenten Temperatursignals. Das hochfrequente Fehlersignal wird in dem Transformator 19 an die Sekundärwicklung weitergegeben und von dort dem zweiten Ausgang 9 des Diplexers 6 zugeführt. An den zweiten Ausgang 9 angeschlossen ist eine Auswerteeinrichtung 14, welche selbstverständlich weitere Filter beinhalten kann und in der das Fehlersignal auswertbar ist. Die Art und Weise der Auswertung entspricht den Anforderungen des Einzelfalls; insbesondere möglich ist eine Auswertung im Hinblick auf Störungen in der elektrischen Maschine. Zur Anzeige solcher Störungen ist die Auswerteeinrichtung 14 versehen mit einem Anzeigeelement 20, beispielhaft als Lampe dargestellt.

Die Erfindung ermöglicht in besonders einfacher und zuverlässiger Weise die Auskopplung eines hochfrequenten Fehlersignals aus einem hochfrequenten elektromagnetischen Feld in einer elektrischen Großmaschine und gestattet insbesondere die Erkennung eines Schadens mit Funkenbildung.

## Patentansprüche

1. Verfahren zur Auskopplung eines hochfrequenten Fehlersignals aus einem hochfrequenten elektromagnetischen Feld in einer elektrischen Großmaschine mit einem eine elektrische Wicklung (1, 2) tragenden Ständer (5),
**dadurch gekennzeichnet,** daß der Ständer (5) mit zumindest einem Temperaturfühler (3, 4) bestückt ist und dieser Temperaturfühler (3, 4) als Antenne zur Auskopplung des Fehlersignals benutzt wird.

2. Verfahren nach Anspruch 1, wobei der Temperaturfühler (3, 4) zur Gewinnung eines Temperatursignals elektrisch betrieben wird.

3. Verfahren nach Anspruch 2, bei dem der Temperaturfühler (3, 4) zur Gewinnung des Temperatursignals mit elektrischer Gleichspannung oder elektrischem Gleichstrom beaufschlagt wird.

4. Verfahren nach Anspruch 2 oder 3, bei dem der Temperaturfühler (3, 4) ein in dem Ständer (5) liegendes Fühlerelement (3) mit daran angeschlossenen, aus dem Ständer (5) herausführenden Anschlußleitungen (4) aufweist.

5. Verfahren nach einem der Ansprüche 2 bis 4, bei dem das Fehlersignal gleichzeitig mit dem Temperatursignal von dem Temperaturfühler (3, 4) abgenommen und von dem Temperatursignal entkoppelt wird.

6. Verfahren nach Anspruch 5, bei dem das Temperatursignal ein niederfrequentes Signal, insbesondere ein Gleichstromsignal, ist.

7. Verfahren nach einem der vorhergehenden Ansprüche, bei dem von einer Vielzahl von Temperaturfühlern (3, 4) Fehlersignale abgenommen werden.

8. Verfahren nach Anspruch 7, bei dem
a) die Temperaturfühler (3, 4) im wesentlichen gleichmäßig über den Ständer (5) verteilt sind;
b) die Fehlersignale der Temperaturfühler (3, 4) miteinander korreliert werden zur Ermittlung einer Stelle (15) in der Großmaschine, wo die Fehlersignale verursacht wurden.

9. Verfahren nach einem der Ansprüche 1 bis 8, bei dem zum Nachweis einer Funkenbildung in der elektrischen Großmaschine aus dem Auftreten eines hochfrequenten Fehlersignals auf die Funkenbildung geschlossen wird.

10. Verfahren nach einem der Ansprüche 1 bis 8, bei dem aus dem Auftreten des Fehlersignals auf einen Schaden in der elektrischen Großmaschine geschlossen wird.

11. Verfahren nach einem der Ansprüche 1 bis 8, bei dem ein Fehlersignal mit einer Frequenz zwischen 1 MHz und 300 MHz, insbesondere zwischen 3 MHz und 100 MHz, ausgekoppelt wird.

12. Vorrichtung zur Auskopplung eines hochfrequenten Fehlersignals aus einem hochfrequenten elektromagnetischen Feld in einer elektrischen Großmaschine mit einem eine elektrische Wicklung (1, 2) tragenden Ständer (5),
**gekennzeichnet durch**
zumindest einen in dem Ständer (5) angeordneten Temperaturfühler (3, 4) zur Erzeugung eines niederfrequenten Temperatursignals, mit Anschlußleitungen (4), die aus dem Ständer (5) herausführen, und einen Diplexer (6) zur Entkopplung des Fehlersignals von dem Temperatursignal, mit einem Eingang (7), einem ersten Ausgang (8) und einem zweiten Ausgang (9), an welchem Eingang (7) die Anschlußleitungen (4) angeschlossen sind, an welchem ersten Ausgang (8) das Temperatursignal und an welchem zweiten Ausgang (9) das Fehlersignal bereitgestellt wird.

13. Vorrichtung nach Anspruch 12, bei der
a) der Temperaturfühler (3, 4) elektrisch zu betreiben ist;
b) der Diplexer (6) bezüglich des ersten Ausgangs (8) als Tiefpaßfilter und bezüglich des zweiten Ausgangs (9) als Hochpaßfilter wirkt.

14. Vorrichtung nach Anspruch 12 oder 13, bei der der Temperaturfühler (3, 4) in einer Nut (10) liegt, welche zu einer Vielzahl von Nuten (10) des Ständers (5) gehört, in welche Wicklungsstäbe (1) der Wicklung (1, 2) eingelegt sind.

15. Vorrichtung nach Anspruch 14, bei der der Temperaturfühler (3, 4) in einer elektrisch isolierenden Zwischenlage (11), die in einer Nut (10) zwischen zwei in der Nut (10) übereinanderliegenden Wicklungsstäben (1) angeordnet ist, liegt.

16. Vorrichtung nach einem der Ansprüche 12 bis 15, bei der der Temperaturfühler (3, 4) ein Widerstandselement (3) mit einem temperaturabhängigen elektrischen Widerstand aufweist.

17. Vorrichtung nach einem der Ansprüche 12 bis 16, welche eine Vielzahl von Temperaturfühlern (3, 4) aufweist, die vorzugsweise gleichmäßig über den Ständer (5) verteilt sind.

## Claims

1. Method for decoupling a high-frequency error signal originating from a high-frequency electromagnetic field in a heavy electrical machine having a stator (5) which carries an electrical winding (1, 2), characterized in that the stator (5) is equipped with at least one temperature sensor (3, 4) and said temperature sensor (3, 4) is utilized as aerial for decoupling the error signal.

2. Method according to Claim 1, wherein the temperature sensor (3, 4) for obtaining a temperature signal is electrically operated.

3. Method according to Claim 2, wherein the temperature sensor (3, 4) for obtaining the temperature signal is supplied with electrical direct voltage or electrical direct current.

4. Method according to Claim 2 or 3, wherein the temperature sensor (3, 4) comprises a sensor element (3) situated in the stator (5) and having connecting leads (4) connected thereto and leading out of the stator (5).

5. Method according to one of Claims 2 to 4, wherein the error signal is picked up from the temperature sensor (3, 4) at the same time as the temperature signal and is decoupled from the temperature signal.

6. Method according to Claim 5, wherein the temperature signal is a low-frequency signal, in particular a direct-current signal.

7. Method according to one of the preceding claims, wherein error signals are picked up from a multiplicity of temperature sensors (3, 4).

8. Method according to Claim 7, wherein
a) the temperature sensors (3, 4) are distributed essentially uniformly over the stator (5);
b) the error signals of the temperature sensors (3, 4) are correlated with one another to determine a position (15) in the heavy machine at which the error signal was caused.

9. Method according to one of Claims 1 to 8, wherein the spark formation is inferred from the occurrence of a high-frequency error signal to detect a spark formation in the heavy electrical machine.

10. Method according to one of Claims 1 to 8, wherein a defect in the heavy electrical machine is inferred from the occurrence of the error signal.

11. Method according to one of Claims 1 to 8, wherein an error signal having a frequency between 1 MHz and 300 MHz, in particular between 3 MHz and 100 MHz, is decoupled.

12. Device for decoupling a high-frequency error signal originating from a high-frequency electromagnetic field in a heavy electrical machine having a stator (5) which carries an electrical winding (1, 2), characterized by at least one temperature sensor (3, 4) disposed in the stator (5) for generating a low-frequency temperature signal and having connecting leads (4) which lead out of the stator (5), and by a diplexer (6) for decoupling the error signal from the temperature signal, having an input (7), a first output (8) and a second output (9), to which input (7) the connecting leads (4) are connected, at which first output (8) the temperature signal is provided and at which second output (9) the error signal is provided.

13. Device according to Claim 12, wherein
a) the temperature sensor (3, 4) is electrically operated;
b) the diplexer (6) acts as a low-pass filter in relation to the first output (8) and as a high-pass filter in relation to the second output (9).

14. Device according to Claim 12 or 13, wherein the temperature sensor (3, 4) is situated in a slot (10) which belongs to a multiplicity of slots (10) in the stator (5) in which winding bars (1) of the winding (1, 2) are laid.

15. Device according to Claim 14, wherein the temperature sensor (3, 4) is situated in an electrically insulating interlayer (11) which is disposed in a slot (10) between two winding bars (1) situated one on top of the other in the slot (10).

16. Device according to one of Claims 12 to 15, wherein the temperature sensor (3, 4) has a resistance element (3) comprising a temperature-dependent electrical resistor.

17. Device according to one of Claims 12 to 16, which has a multiplicity of temperature sensors (3, 4) which are distributed preferably uniformly over the stator (5).

## Revendications

1. Procédé de découplage d'un signal d'erreur haute fréquence d'un champ électromagnétique haute fréquence dans une machine électrique de grande dimension équipée d'un stator (5) portant un enroulement électrique (1, 2), caractérisé en ce que le stator (5) est muni d'au moins un palpeur de température (3, 4) et en ce que ledit palpeur de température (3, 4) est utilisé comme antenne de découplage du signal d'erreur.

2. Procédé selon la revendication 1, le palpeur de température (3, 4) étant commandé par électricité pour obtenir un signal de température.

3. Procédé selon la revendication 2, dans lequel le palpeur de température (3, 4) est alimenté en tension électrique continue ou en courant électrique continu pour obtenir ledit signal de température.

4. Procédé selon la revendication 2 ou 3, dans lequel le palpeur de température (3, 4) comporte un élément palpeur (3) placé dans le stator (5), auquel sont raccordées des lignes de raccordement (4) sortant du stator (5).

5. Procédé selon l'une quelconque des revendications 2 à 4, dans lequel le signal d'erreur est réceptionné en même temps que le signal de température par le palpeur de température (3, 4) et découplé du signal de température.

6. Procédé selon la revendication 5, dans lequel le signal de température est un signal basse fréquence, en particulier un signal de courant continu.

7. Procédé selon l'une quelconque des revendications précédentes, dans lequel des signaux d'erreur sont réceptionnés par une pluralité de palpeurs de température (3, 4).

8. Procédé selon la revendication 7, dans lequel
a) les palpeurs de température (3, 4) sont répartis essentiellement uniformément sur le stator (5) ;
b) une corrélation est établie entre les signaux d'erreur des palpeurs de température (3, 4) pour détecter dans la machine de grande dimension un endroit (15) où les signaux d'erreurs ont été provoqués.

9. Procédé selon l'une quelconque des revendications 1 à 8, dans lequel, pour démontrer une formation d'étincelles dans la machine électrique de grande dimension, on induit ladite formation d'étincelles de l'apparition d'un signal d'erreur haute fréquence.

10. Procédé selon l'une quelconque des revendications 1 à 8, dans lequel on induit une défaillance dans la machine électrique de grande dimension de l'apparition dudit signal d'erreur.

11. Procédé selon l'une quelconque des revendications 1 à 8, dans lequel un signal d'erreur avec une fréquence comprise entre 1 MHz et 300 MHz, en particulier entre 3 MHz et 100 Mhz, est découplé.

12. Dispositif de découplage d'un signal d'erreur haute fréquence d'un champ électromagnétique haute fréquence dans une machine électrique de grande dimension équipée d'un stator (5) portant un enroulement électrique (1, 2), caractérisé par au moins un palpeur de température (3, 4) disposé dans le stator (5) pour produire un signal de température basse fréquence, comportant des conduites de raccordement (4) sortant du stator (5) et un diplexeur (6) pour découpler le signal d'erreur du signal de température, comportant une entrée (7), une première sortie (8) et une deuxième sortie (9), à laquelle entrée (7) sont raccordées les conduites de raccordement (4), à laquelle première sortie (8) est mis à disposition le signal de température et à laquelle deuxième sortie (9) est mis à disposition le signal d'erreur.

13. Dispositif selon la revendication 12, dans lequel
a) le palpeur de température sera commandé par électricité ;
b) le diplexeur (6) agit pour ce qui concerne la première sortie (8) comme filtre passe-bas et pour ce qui concerne la deuxième sortie (9) comme filtre passe-haut.

14. Dispositif selon la revendication 12 ou 13, dans lequel le palpeur de température (3, 4) est placé dans une rainure (10) faisant partie d'une pluralité de rainures (10) du stator (5), dans lesquelles sont insérées des barres d'enroulement (1) de l'enroulement (1, 2).

15. Dispositif selon la revendication 14, dans lequel le palpeur de température (3, 4) est placé dans une couche intermédiaire (11) électriquement isolante, qui est disposée dans une rainure (10) entre deux barres d'enroulement (1) posées l'une sur l'autre dans la rainure (10).

16. Dispositif selon l'une des revendications 12 à 15, dans lequel le palpeur de température (3, 4) comporte un élément de résistance (3) avec une résistance électrique dépendante de la température.

17. Dispositif selon l'une des revendications 12 à 16, qui comporte une pluralité de palpeurs de température (3, 4), qui sont répartis de préférence uniformément sur le stator (5).
